# FASCICULE DE BREVET EUROPEEN

(11) **EP 2 210 271 B1**
(45) Date de publication et mention de la délivrance du brevet: **30.03.2011**
(21) Numéro de dépôt: 08856915.7
(22) Date de dépôt: 18.11.2008
(51) Int. Cl.: H01L 21/68, H01L 21/00

(54) **Dispositif et procédé d'alignement de plaquettes sur un support plan**
Vorrichtung und Verfahren zur ausrichtung von Wafern auf einer flachen Oberfläche
Device and method for aligning wafers on a flat support

(30) Priorité: 19.11.2007 FR 0708106
(43) Date de publication de la demande: 28.07.2010
(73) Titulaire: Centre National d'Etudes Spatiales (C.N.E.S.), 75039 Paris Cedex 01 (FR)
(72) Inventeur: PENQUER, Antoine, 31400 Toulouse (FR); EHANNO, Michel, F-82210 Angeville (FR)
(74) Mandataire: Cabinet BARRE LAFORGUE & associés
(86) Numéro de dépôt international: PCT/FR2008/052071
(87) Numéro de publication internationale: WO 2009/071790

(56) Documents cités:
- FR-A- 2 798 774
- JP-A- 11 284 056
- JP-A- 58 070 545

## Description

L'invention concerne un dispositif et un procédé d'alignement de plaquettes sur un support plan.

Dans tout le texte, le terme « plaquette » désigne un élément solide qui comprend au moins une face présentant une portion plane adaptée pour être en appui-plan sur un support plan, et qui présente une dimension dans l'épaisseur inférieure aux dimensions dans la largeur et dans la longueur.

Il existe de nombreux domaines techniques dans lesquels des plaquettes doivent être alignées précisément sur un support plan en vue par exemple de faciliter leur collage sur un substrat solide.

De telles plaquettes sont par exemple des cristaux semi-conducteurs parallélépipédiques utilisés pour fabriquer des détecteurs de rayonnements X ou gamma. Ces cristaux semi-conducteurs doivent être précisément alignés sur un support plan sans contact entre eux aux fins de permettre un collage ultérieur de ces cristaux semi-conducteurs sur une plaque de céramique.

Les ordres de grandeur des dimensions d'une plaquette peuvent être de tous types. Une plaquette peut présenter une hauteur de l'ordre de 1 cm et des dimensions radiales de l'ordre de 5 cm à 10 cm.

Rien n'empêche néanmoins de prévoir des plaquettes présentant une hauteur supérieure à 1 cm, notamment de l'ordre de 10 cm, et des dimensions radiales supérieures à 10 cm, notamment de l'ordre de 50 cm.

Dans le cas d'applications de détection de rayonnements X ou gamma, les plaquettes peuvent par exemple présenter une hauteur de l'ordre de 2 mm et des dimensions radiales de l'ordre de 4 mm.

Dans de telles applications, il est fréquent de rechercher à aligner les cristaux de telle sorte que deux cristaux adjacents soient espacés l'un de l'autre d'une distance l'ordre de 300 µm. Cette distance définit la précision de l'alignement des cristaux.

Le procédé de collage de cristaux semi-conducteurs parallélépipédiques sur une plaque de céramique comprend de manière connue une étape d'alignement des cristaux sur un support plan de réception des cristaux suivant une mosaïque prédéterminée et une étape ultérieure de plaquage de la plaque de céramique, dont une face a été revêtue d'une pluralité de points de colle, contre les cristaux alignés sur le support plan de réception. Après un laps de temps prédéterminé pendant lequel les points de colle sèchent, la plaque de céramique est retirée du support plan et retournée. Les cristaux sont ainsi collés sur la plaque de céramique suivant la mosaïque prédéterminée.

Dans le cas de la réalisation de détecteurs X ou gamma, la précision des détections des rayonnements et la précision des informations résultant de ces détections dépend principalement de la précision de l'agencement des cristaux les uns par rapport aux autres, en particulier des alignements.

L'étape d'alignement des cristaux sur le support plan peut être réalisée par l'utilisation d'un dispositif d'alignement des cristaux sur un support plan; comme par exemple les documents

FR 27 98774 A, JP 11284056 A et JP 58070545 décrivent des dispositifs et des procédés d'alignement de plaquettes.

Il est connu d'utiliser un pochoir dans lequel sont ménagés des orifices de réception des cristaux. Ce pochoir est placé sur le support plan. Les cristaux sont disposés dans les orifices du pochoir, et la plaque de céramique encollée est plaquée contre les cristaux agencés dans les orifices du pochoir.

La précision du collage des cristaux sur la plaque de céramique dépend donc de la précision de l'alignement des cristaux sur le support plan. Il est en pratique possible de réaliser des pochoirs dont les orifices sont précisément alignés et espacés les uns des autres d'une distance de l'ordre de 300 µm. Il est en revanche beaucoup plus difficile en pratique de réaliser des pochoirs dont les orifices sont espacés les uns des autres d'une distance inférieure à 300 µm, notamment de l'ordre de 80 µm. Une telle précision nécessite en particulier l'utilisation de technologies de pointes, rendant onéreuses les opérations de positionnement et d'alignement des cristaux sur un support plan.

De plus, un tel dispositif présente par conception un jeu entre chaque orifice et chaque cristal de manière à permettre l'insertion des cristaux dans les orifices. En particulier, les cristaux ne doivent pas être mis en contact avec les parois des orifices dans lesquels ils sont agencés pour ne pas risquer de les rayer. Chaque cristal logé dans un orifice est donc susceptible de pivoter et d'altérer l'alignement des cristaux sur le support plan.

Un tel dispositif d'alignement est donc en réalité assez peu fiable. En particulier, la précision de l'alignement des cristaux sur le support plan dépend essentiellement de la dextérité de l'opérateur chargé de la pose de ces cristaux. En outre, quelle que soit la dextérité de l'opérateur, la précision obtenue est altérée et limitée par les jeux inhérents entre les orifices et les plaquettes.

L'invention vise à pallier ces inconvénients et à fournir un dispositif d'alignement de plaquettes sur un support plan permettant d'obtenir un alignement dont la précision est indépendante de l'opérateur chargé de la pose des plaquettes sur le support plan.

L'invention vise également à fournir un dispositif d'alignement de plaquettes dont la précision est améliorée par rapport aux dispositifs de l'art antérieur.

L'invention vise également à fournir un tel dispositif qui permet d'atteindre une précision de l'ordre de 300 µm, et ce de manière répétitive.

L'invention vise également à fournir un tel dispositif qui permet d'atteindre une précision de l'ordre de 80 µm, et ce de manière répétitive.

L'invention vise également à fournir un tel dispositif qui est économique à réaliser.

L'invention vise également à fournir un tel dispositif qui est simple et rapide à utiliser.

L'invention vise également à fournir un tel dispositif qui préserve l'intégrité des plaquettes et est compatible avec l'emploi de plaquettes fragiles telles que des cristaux de matériaux semi-conducteurs.

L'invention vise également à fournir un procédé d'alignement de plaquettes sur un support plan.

Pour ce faire l'invention concerne un dispositif d'alignement de plaquettes sur un support plan comprenant :
- un corps fixe par rapport au support plan, caractérisé en ce qu'il comprend :
- des fils de guidage agencés au-dessus du support plan et délimitant une pluralité de mailles,
- des dispositifs de traction des fils de guidage, ces dispositifs de traction étant fixés sur le corps et adaptés pour permettre le placement des fils de guidage :
   dans au moins une première position, dite position de pose, dans laquelle ils sont détendus de façon à permettre l'insertion de plaquettes dans les mailles délimitées par ces fils de guidage,
   dans au moins une deuxième position, dite position d'alignement, dans laquelle les fils de guidage sont tendus et s'étendent au-dessus du support plan de façon à définir des mailles aptes à loger, et à maintenir en place sur le support plan, des plaquettes circonscrites latéralement par les fils de guidage, ces plaquettes étant alignées les unes par rapport aux autres le long des fils de guidage tendus, deux plaquettes logées dans des mailles adjacentes étant espacées l'une de l'autre d'une distance correspondant exactement au diamètre du fil de guidage tendu les séparant.

Un dispositif selon l'invention permet ainsi à un opérateur de placer, dans un premier temps, les plaquettes sur le support plan de réception des plaquettes sans se soucier réellement des positions relatives des plaquettes les unes par rapport aux autres, c'est-à-dire, sans se soucier de l'alignement de chaque plaquette avec les plaquettes voisines. L'opérateur doit seulement faire en sorte de déposer chaque plaquette sur le support plan de réception des plaquettes de telle manière qu'elle soit placée à l'intérieur d'une maille formée par des fils de guidage en position de pose. Cette dépose est relativement aisée étant donné que les fils de guidage sont détendus. Ainsi, en position de pose, les fils formant cette maille étant détendus, ils peuvent être écartés légèrement pour présenter des dimensions radiales supérieures aux dimensions radiales de la plaquette qu'elle doit recevoir. Un opérateur est donc à même, si nécessaire, d'écarter légèrement les fils de guidage formant chaque maille pour y loger une plaquette.

Un dispositif selon l'invention permet ensuite dans un deuxième temps d'exercer une traction ayant pour effet de mettre les fils de guidage en tension de sorte que chaque plaquette préalablement logée dans une maille par l'opérateur, est circonscrite latéralement par les fils de guidage tendus formant cette maille. Dès lors, chaque fil de guidage tendu qui définit au moins une portion d'une maille dans laquelle est logée une plaquette est en contact avec une portion périphérique latérale de cette plaquette.

Chaque plaquette est alors étroitement enserrée par les fils de guidage formant la maille dans laquelle la plaquette est logée. Les différents fils de guidage formant cette maille exercent ainsi chacun une pression sur une portion périphérique de la plaquette. La résultante de ces différentes pressions entraîne, si nécessaire, un déplacement de la plaquette sur le support de réception jusqu'à une position d'équilibre. Chaque fil de guidage est rectiligne lorsqu'il est mis en tension. Dès lors, les différentes plaquettes encadrées par les mêmes fils de guidage sont parfaitement alignées le long de ces fils de guidage lorsque chaque plaquette a atteint sa position d'équilibre. Lorsque ces positions d'équilibre sont atteintes, deux plaquettes adjacentes sont espacées l'une de l'autre du diamètre du fil de guidage en tension les séparant.

En d'autres termes, un dispositif selon l'invention comprend des dispositifs de traction des fils de guidage, ces dispositifs de traction étant fixés sur le corps et adaptés pour permettre le déplacement des fils de guidage d'au moins une première position, dite position de pose, dans laquelle les fils de guidage sont détendus de sorte que les mailles délimitées par ces fils de guidage puissent présenter des formes et dimensions radiales supérieures aux dimensions radiales des plaquettes pour que chaque plaquette puisse être agencée dans une maille, à au moins une deuxième position, dite position d'alignement, dans laquelle les fils de guidage sont maintenus en tension au-dessus du support plan de sorte que chaque plaquette logée dans une maille est circonscrite latéralement par les fils de guidage formant cette maille, de manière à assurer un alignement des plaquettes les unes par rapport aux autres le long des fils de guidage; deux plaquettes adjacentes étant espacées l'une de l'autre du diamètre du fil de guidage en traction les séparant.

Pour chaque plaquette, le passage de la position initiale de repos à l'intérieur d'une maille à la position d'équilibre résultant de la coopération des fils de guidages en tension est quasiment immédiat, les frottements entre chaque plaquette et le support de réception des plaquettes étant négligeables par rapport aux forces exercées par les fils de guidage en tension sur les plaquettes.

La traction sur les fils de guidage est opérée par l'intermédiaire de dispositifs de traction des fils de guidage. Ces dispositifs de traction sont fixés sur le corps du dispositif selon l'invention. Ces dispositifs de traction sont adaptés pour assurer la mise en tension des fils de guidage depuis la position de pose dans laquelle les fils de guidage sont détendus, à au moins une position d'alignement dans laquelle les fils de guidage sont maintenus en tension au-dessus du support plan de sorte que chaque plaquette logée dans une maille est circonscrite latéralement par les fils de guidage formant cette maille. Plusieurs positions d'alignement distinctes peuvent être prévues pour l'alignement de diverses formes et/ou dimensions de plaquettes.

Un dispositif selon l'invention permet donc d'obtenir un alignement des plaquettes sur un support plan dont la précision de l'alignement est indépendante de l'opérateur chargé de la pose des plaquettes sur le support plan.

Chaque fil de guidage s'étend au-dessus du support plan et forme au moins une maille avec au moins un autre fil de guidage s'étendant au-dessus du support plan.

Les dispositifs de traction pour le maintien et la traction de chaque fil de guidage peuvent faire l'objet de divers modes de réalisation. En particulier, le corps du dispositif peut présenter diverses formes et dimensions pour faciliter le maintien rectiligne des fils de guidage au-dessus du support plan horizontal.

Avantageusement et selon l'invention, chaque plaquette présente une épaisseur e et les dispositifs de traction des fils de guidage sont adaptés pour que, en position d'alignement, chaque fil de guidage s'étende parallèlement au support plan à une distance *d* du support plan inférieure à l'épaisseur e des plaquettes.

En position d'alignement, la distance du support plan de laquelle s'étend un fil de guidage n'est pas nécessairement égale à la distance du support plan de laquelle s'étend un fil de guidage adjacent à ce fil de guidage.

En particulier, pour un maillage carré formé d'une première série de fils de guidage qui s'étend dans une première direction et d'une seconde série de fils de guidage qui s'étend dans une seconde direction perpendiculaire à la première direction, les fils de guidage de la première série peuvent s'étendre, en position d'alignement, à une distance *d1* du support plan et les fils de guidage de la seconde série s'étendent à une distance d2 du support plan, inférieure à *d1,* de telle sorte que les fils de guidage de la première série sont agencés au dessus des fils de guidage de la seconde série.

Avantageusement et selon l'invention, le corps comprend :
- une portion périphérique entourant au moins partiellement le support plan et sur laquelle sont fixés les dispositifs de traction des fils de guidage,
- une pluralité de fentes, chaque fente :
   . s'étendant radialement entre la périphérie du corps et le support plan,
   . s'étendant entre une face supérieure du corps et un fond de fente parallèle au support plan agencé à une distance *d* au-dessus du support plan,
   étant axialement en regard d'une autre fente agencée dans le corps à l'opposé de cette fente par rapport au support plan de manière que ces fentes, axialement en regard l'une de l'autre, d'un côté et de l'autre du support plan, forment une paire de fentes de guidage rectiligne d'un fil de guidage.

Le corps d'un dispositif selon cette variante de l'invention présente une pluralité de paires de fentes coplanaires coaxiales. Chaque fente présente un fond de fente parallèle au support plan de réception des plaquettes et agencé à une distance *d* au-dessus du support plan de réception des plaquettes. Les deux fentes de chaque paire de fentes sont agencées de part et d'autre du support plan de réception des plaquettes de telle sorte qu'elles sont à même de permettre le maintien d'un fil de guidage logé dans ces deux fentes, rectiligne et parallèle au support de réception des plaquettes à une distance *d* du support plan.

Selon une variante de l'invention, la portion périphérique du corps d'un dispositif selon l'invention entoure entièrement le support plan de telle sorte que les fentes peuvent être ménagées entre la périphérie du corps et le support plan de manière à entourer le support plan et permettre le maintien de fils de guidage au-dessus de toutes portions du support plan. Ainsi, un dispositif selon cette variante permet la formation de tous types de maillage présentant tous types de formes et dimensions. Un maillage est défini par la disposition des fentes sur la portion périphérique du corps du dispositif et par l'introduction dans chaque paire de fentes, d'un fil de guidage relié à un dispositif de traction d'un fil de guidage.

Une fente est délimitée par deux parois verticales radiales parallèles l'une à l'autre et espacées l'une de l'autre d'une distance prédéterminée. Dans tout le texte, la distance séparant deux parois verticales radiales formant une fente est dite largeur de la fente.

De préférence, la largeur d'une fente correspond exactement au diamètre du fil de guidage détendu logé dans cette fente.

Néanmoins, selon une variante de l'invention, la largeur d'une fente est supérieure de 1% à 2% au diamètre du fil de guidage tendu qu'elle doit guider. Cela permet d'une part de bien maintenir le fil de guidage, ce dernier étant maintenu étroitement entre les deux parois verticales formant cette fente et d'autre part de faciliter le glissement de ce fil de guidage dans la fente lors de la tension du fil par les dispositifs de traction.

Avantageusement, un dispositif selon l'invention comprend en outre des fentes, dites fentes de bordure, ménagées dans le corps du dispositif de sorte que des fils de guidage placés dans ces fentes de bordure s'étendent le long de bords périphériques du support plan.

De telles fentes de bordure permettent de ménager des fils de guidage le long des bords latéraux du support plan, ce qui permet de ménager des espaces, de dimension égale au diamètre des fils de guidage logés dans ces fentes de bordure, entre les bords du support plan et les plaquettes.

Avantageusement et selon l'invention, lesdites fentes sont ménagées dans le corps du dispositif de sorte que le maillage constitué par les fils de guidage placés dans les fentes est un maillage carré.

Un tel dispositif permet de réaliser des maillages carrés, c'est-à-dire des quadrillages réguliers du support plan. Selon cette variante, chaque plaquette présente avantageusement une forme périphérique adaptée pour être circonscrite par un carré, c'est-à-dire une forme polygonale à nombre pair de côtés, de côtés opposés parallèles deux à deux, ou une forme circulaire. Une telle plaquette présente par exemple une forme périphérique carrée.

Un tel dispositif présente donc deux séries de fentes perpendiculaires. Chaque série de fentes comprend une pluralité de paires de fentes réparties respectivement de part et d'autre du support plan. Chaque fente de la première série de fentes est perpendiculaire à chaque fente de la seconde série de fentes de sorte que des fils de guidage qui passent respectivement dans chacune de ces fentes soient perpendiculaires et puissent former une portion du maillage carrée. Pour ce faire, chaque fente d'une série de fentes est espacée des fentes adjacentes de cette série de fentes d'une distance égale à la dimension d'un côté d'une plaquette.

Selon une variante de l'invention, un dispositif de traction d'un fil de guidage peut comprendre des taquets coinceurs agencés de part et d'autre du support plan de réception des plaquettes, en regard de chacune des fentes de la paire de fentes dans lesquelles est passé ce fil de guidage. Un opérateur peut alors tirer sur ce fil de guidage et le déplacer d'une position de pose dans laquelle ce fil de guidage est détendu à une position d'alignement dans laquelle ce fil est maintenu par les taquets coinceurs en tension parallèlement au support plan de réception des plaquettes.

Un dispositif de traction d'un fil de guidage peut selon une autre variante comprendre un système de pinces commandées électroniquement. Un tel dispositif comprend des pinces adaptées pour pincer le fil de guidage et tracter ce dernier jusqu'à ce qu'il présente une tension prédéterminée. Une première extrémité de ce fil de guidage est fixée directement sur le corps du dispositif d'alignement en regard d'une fente ou par l'intermédiaire d'un organe de maintien d'un fil fixé sur le corps, tel qu'un crampillon ou un organe équivalent. L'autre extrémité de ce fil de guidage est insérée dans le système à pinces commandées électroniquement agencé en regard de la fente opposée à la fente en regard de la première extrémité. Ces deux fentes forment une paire de fentes, telle que précédemment décrite.

Avantageusement et selon l'invention, chaque dispositif de traction comprend :
- au moins un ressort présentant une première extrémité fixée au corps du dispositif et une seconde extrémité reliée à une première extrémité d'un fil de guidage,
- au moins une poignée mobile de traction agencée à l'opposé du ressort par rapport au support plan et reliée à une deuxième extrémité de ce fil de guidage et adaptée pour passer d'au moins d'une première position dans laquelle ce fil de guidage et ce ressort sont détendus à au moins une deuxième position dans laquelle ce fil de guidage et ce ressort sont en tension.

Selon cette variante, le dispositif de traction d'un fil est manuel et comprend une poignée mobile en regard d'un ressort par rapport au support plan, chaque fil de guidage étant fixé respectivement à la poignée et au ressort de telle sorte qu'une action sur la poignée permet d'agir sur le fil et sur le ressort de manière à permettre une traction du fil assurant une mise sous tension de ce dernier. Selon une variante avantageuse de l'invention, le corps comprend en outre, du côté de la poignée mobile, un loquet mobile adapté pour présenter une position dans laquelle il bloque la poignée mobile dans la position dans laquelle le fil de guidage et le ressort sont en traction de manière à maintenir les fils de guidage en tension et faciliter les manipulations ultérieures par un opérateur.

Une poignée présente une structure adaptée pour entraîner la traction d'un ou de plusieurs fils de guidage.

Selon l'invention, chaque fil de guidage est agencé au-dessus du support plan à une distance *d* du support, inférieure à *e*.

Avantageusement et selon l'invention, *d* est sensiblement égal à e/2.

Bien entendu, dans le cas de fils de guidage se chevauchant, les fils de guidage chevauchés seront agencés à une distance légèrement inférieure à la distance à laquelle sont agencés les fils chevauchants.

Des distances voisines de *e*/2 permettant de garantir que les fils de guidage agiront, lorsque mis en tension, sur les parties médianes des plaquettes. Pour des plaquettes parallélépipédiques homogènes, ces parties médianes comprennent le centre de gravité des plaquettes. Or, le déplacement d'un objet en translation sur une surface plane est facilité lorsque la force exercée sur lui est appliquée au niveau de son centre de gravité.

Les fils de guidage d'un dispositif selon l'invention peuvent être de tous types.

De préférence, ces fils sont faiblement élastiques en traction de manière que leur diamètre ne varie que légèrement entre la position dans laquelle ils sont détendus et la position dans laquelle ils sont en traction.

Avantageusement et selon l'invention, au moins un fil de guidage -notamment chaque fil de guidage- est un fil en nylon.

Ces fils de guidage -notamment dans le cas où ces fils de guidage sont en nylon- peuvent présenter tous types de diamètres. Le diamètre des fils de guidage détermine, en combinaison avec l'espacement des fentes ménagées dans le corps du dispositif, la distance entre les plaquettes alignées sur le support de réception des plaquettes. Ainsi, le diamètre des fils de guidage doit être choisi en fonction de l'application visée.

Selon une variante de l'invention, au moins un fil de guidage -notamment chaque fil de guidage- est un fil dont le diamètre en traction est de 300 µm de telle sorte que deux plaquettes adjacentes séparées par ce fil de guidage sont espacées l'une de l'autre de 300 µm.

Selon une autre variante de l'invention, au moins un fil de guidage -notamment chaque fil de guidage- est un fil dont le diamètre en traction est de 80 µm de telle sorte que deux plaquettes adjacentes séparées par ce fil de guidage sont espacées l'une de l'autre de 80 µm.

Ainsi, un dispositif selon l'invention permet de réaliser, sans le recours à des technologies de pointe complexes, et de manière économique, des alignements de plaquette permettant que deux plaquettes adjacentes soient espacées l'une de l'autre d'une distance de 80 µm.

Un dispositif selon l'invention présente un support plan de réception des plaquettes sur lequel les plaquettes sont alignées le long des fils de guidage par un actionnement des dispositifs de traction des fils de guidage. Un dispositif selon l'invention comprend également un corps fixe par rapport au support plan de réception des plaquettes.

Un dispositif selon l'invention peut être formé de plusieurs pièces assemblées les unes aux autres. En variante, de préférence et selon l'invention, le corps et le support plan de réception des plaquettes sont formés d'un seul tenant, notamment d'une même pièce rigide usinée ou moulée.

Dans un mode de réalisation, avantageusement et selon l'invention, le corps comprend un logement de réception des plaquettes formé du support plan de réception des plaquettes et de flancs latéraux s'étendant perpendiculairement au support plan de manière à délimiter latéralement le support plan de réception des plaquettes.

En d'autres termes, selon ce mode de réalisation de l'invention, le corps présente un évidement formant un logement de réception des plaquettes. Cet évidement présente une surface plane formant le fond du logement de réception. Ce fond de logement de réception forme le support plan. Par ailleurs, l'évidement présente des parois latérales verticales s'étendant perpendiculairement au fond du logement de réception. Dès lors, les plaquettes placées sur les bords du support plan de réception des plaquettes sont bloquées latéralement par ces parois verticales.

Avantageusement et selon l'invention, le logement de réception présente une forme et des dimensions adaptées pour permettre la réception au-dessus des plaquettes d'un substrat solide adapté pour être plaqué contre les plaquettes parallèlement au support plan, les plaquettes étant ainsi prises en sandwich entre le support plan de réception des plaquettes et ce substrat solide.

Cela permet par exemple dans un procédé de collage de plaquettes sur un substrat mettant en oeuvre un dispositif selon l'invention de venir plaquer le substrat dont une face aura été préalablement encollée sur les plaquettes pour assurer le collage des plaquettes sur le substrat.

Selon cette variante, avantageusement et selon l'invention, le logement de réception comporte un épaulement périphérique adapté pour recevoir une portion périphérique du substrat solide de manière à délimiter, une fois le substrat solide plaqué contre l'épaulement périphérique, un espace entre la surface supérieure des plaquettes et la surface inférieure du substrat solide logé dans ce logement de réception.

Cet espace ménagé entre la surface inférieure d'un substrat logé dans le logement de réception et les surfaces supérieures des plaquettes permet d'éviter, dans le cas de l'utilisation d'un dispositif selon l'invention dans un procédé de collage de plaquettes alignées sur un substrat solide, l'écrasement du substrat solide sur les plaquettes. Cet espace est destiné à recevoir la couche de colle ménagée sur la surface inférieure d'un substrat solide.

Selon cette variante de l'invention et dans le cas où un dispositif selon l'invention comprend des fentes de bordure, avantageusement les fentes de bordure sont adaptées pour recevoir un fil de guidage présentant un diamètre en traction de 150 µm de telle sorte que les plaquettes agencées aux bords du support de réception des plaquettes puissent être espacées du bord d'un substrat solide logé dans le logement de réception d'une distance égale à 150 µm.

Un dispositif selon l'invention est particulièrement adapté pour assurer un alignement de plaquettes parallélépipédiques sur un support plan, en vue de réaliser des capteurs de détection de rayonnements X ou gamma.

Avantageusement et selon l'invention, les plaquettes sont des cristaux parallélépipédiques adaptés pour permettre la détection de rayonnements X ou gamma, chaque cristal présentant une épaisseur e de l'ordre de 2 mm.

L'invention vise également un procédé d'alignement de plaquettes sur un support plan.

Selon l'invention, un procédé d'alignement de plaquettes sur un support plan est caractérisé en ce qu'il comprend les étapes suivantes :
- une pluralité de fils de guidage est disposée au-dessus du support plan de manière à délimiter une pluralité de mailles,
- les fils de guidage sont placés dans une première position, dite position de pose, dans laquelle ils sont détendus de façon à permettre l'insertion desdites plaquettes dans les mailles délimitées par ces fils de guidage,
- chaque plaquette à aligner sur le support plan est agencée dans une maille de sorte qu'une fois positionnée, elle repose sur le support plan et est entourée par les fils de guidage définissant la maille dans laquelle cette plaquette est agencée,
- les fils de guidage sont placés dans une deuxième position, dite position d'alignement, dans laquelle les fils de guidage sont tendus et s'étendent au-dessus du support plan de façon à définir des mailles aptes à loger, et à maintenir en place sur le support plan, lesdites plaquettes circonscrites latéralement par les fils de guidage, ces plaquettes étant alignées les unes par rapport aux autres le long des fils de guidage tendus, deux plaquettes logées dans des mailles adjacentes étant espacées l'une de l'autre d'une distance correspondant exactement au diamètre du fil de guidage tendu les séparant.

Un procédé d'alignement selon l'invention est par exemple mis en oeuvre pour la fabrication d'un substrat solide comprenant une pluralité de plaquettes alignées et collées sur ce substrat solide.

Pour ce faire, le collage des plaquettes sur un substrat solide nécessite, une fois les plaquettes alignées sur le support plan, la mise en oeuvre des étapes suivantes :
- une pluralité de points de colle est déposée sur une face du substrat solide, dite face collante, la répartition des points de colle sur la face collante du substrat solide étant sensiblement identique à la répartition des plaquettes sur le support plan,
- le substrat est agencé sur les plaquettes, la face collante vers les plaquettes, et plaqué contre les plaquettes,
- après un laps de temps prédéterminé pendant lequel la colle sèche, les fils sont détendus,
- le substrat est éloigné du support de réception des plaquettes, les plaquettes étant collées sur ce dernier suivant le maillage précédemment défini par la pluralité de fils.

Dans le cas où un dispositif selon l'invention comprend un épaulement périphérique adapté pour recevoir une portion périphérique du substrat solide de manière à délimiter un espace entre la surface supérieure des plaquettes et la surface inférieure du substrat solide logé dans ce logement de réception, l'étape de plaquage du substrat solide sur les plaquettes est remplacée par une étape de plaquage du substrat solide contre l'épaulement périphérique. La distance entre le fond du logement de réception des plaquettes et cet épaulement périphérique est calculée de manière que le plaquage du substrat solide sur l'épaulement périphérique permette le collage de chaque plaquette sur le substrat par l'intermédiaire d'un point de colle, tout en empêchant que le substrat solide n'exerce une pression trop forte sur les plaquettes.

Pour permettre le collage de plaquettes sur un substrat plan, ces plaquettes étant alignées par un procédé d'alignement selon l'invention, chaque plaquette est posée à l'envers sur le support plan de telle sorte que lorsque le substrat sur lequel cette plaquette doit être collée est plaqué contre cette plaquette, ou le cas échéant, contre l'épaulement périphérique d'un dispositif selon l'invention, elle présente au substrat la face destinée à être collée sur le support, la face en contact du support plan étant la face non collée.

Le substrat est de préférence un substrat plan.

Un procédé selon l'invention qui utilise un dispositif selon l'invention permet d'aligner les plaquettes sur un support plan et d'assurer par exemple un collage des plaquettes sur un substrat solide dont l'alignement des plaquettes présente une précision indépendante de l'opérateur chargé de la pose des plaquettes sur le support plan.

En particulier, un procédé selon l'invention permet d'obtenir un alignement des plaquettes sur un support plan dont la précision est de l'ordre de 300 µm.

En outre, un tel procédé d'alignement est économique à mettre en oeuvre et préserve l'intégrité des plaquettes.

L'étape de dépose de chaque plaquette dans une maille formée par les fils de guidage peut être réalisée par l'utilisation de divers moyens.

Néanmoins, avantageusement et selon l'invention, chaque plaquette est agencée dans une maille du maillage formé par les fils de guidage avec l'aide d'un stylo pompe CMS.

Un stylo pompe CMS permet une manipulation de composants présentant une surface plane au moyen d'une pompe à dépression.

L'utilisation d'un tel stylo pompe permet de limiter les risques de rayer ou d'abîmer les plaquettes.

Un procédé selon l'invention est particulièrement adapté à l'alignement de cristaux en vue de permettre par exemple le collage de ces cristaux sur une céramique.

Selon un mode de réalisation de l'invention, les plaquettes sont des cristaux parallélépipédiques, adaptées pour permettre la détection de rayonnements X ou gamma.

De tels cristaux peuvent être collés sur une plaque de céramique.

L'invention vise en outre un dispositif et un procédé d'alignement de plaquettes sur un support plan caractérisés par tout ou partie des caractéristiques mentionnées ci-avant ou ci-après.

D'autres caractéristiques, buts et avantages de l'invention apparaîtront à la lecture de la description suivante qui présente à titre d'exemple non limitatif un mode de réalisation de l'invention, en référence aux dessins annexés ; sur ces dessins :
- la figure 1 est une vue schématique en perspective d'un dispositif d'alignement de plaquettes sur un support plan selon un mode de réalisation de l'invention,
- les figures 2a et 2b sont des vues schématiques respectivement de dessus et en coupe transversale du dispositif de la figure 1 sur lesquelles des fils de guidage formant des mailles de réception d'une plaquette sont détendus,
- les figures 3a et 3b sont des vues schématiques respectivement de dessus et en coupe transversale du dispositif de la figure 1 sur lesquelles des plaquettes sont logées dans les mailles formées par les fils de guidage détendus,
- les figures 4a et 4b sont des vues schématiques respectivement de dessus et en coupe transversale du dispositif de la figure 1 sur lesquelles les fils de guidage sont en traction de telle sorte que chaque plaquette logée dans une maille formée par ces fils de guidage en traction est circonscrite par ces fils de guidage de manière à aligner les plaquettes le long des fils de guidage,
- la figure 5 est une vue schématique en perspective d'un substrat solide plan présentant une face revêtue d'une pluralité de points de colle destinée à être plaquée contre les plaquettes alignées sur le support de réception des plaquettes par un dispositif d'alignement selon l'invention,
- les figures 6a et 6b sont des vues schématiques respectivement de dessus et en coupe transversale du dispositif de la figure 1 sur lesquelles un substrat solide présentant une face revêtue d'une pluralité de points de colle a été plaqué contre les plaquettes alignées sur un support plan, les fils de guidage étant en traction,
- la figure 7 est une vue schématique en perspective du substrat solide des figures 5, 6a et 6b extrait du dispositif d'alignement selon l'invention et présentant des plaquettes alignées et collées sur une de ses faces,
- la figure 8 est une vue schématique en perspective d'un dispositif selon un mode de réalisation de l'invention comprenant un logement de réception muni d'un épaulement périphérique adapté pour recevoir un substrat solide plan de manière à limiter l'écrasement des points de colle lors du plaquage du substrat solide,
- la figure 9a est une vue schématique en coupe transversale du dispositif de la figure 8 sur laquelle un substrat solide présentant une face revêtue d'une pluralité de points de colle a été plaqué contre l'épaulement périphérique, les fils de guidage étant en traction,
- la figure 9b est une vue schématique en perspective du substrat solide plan extrait du dispositif d'alignement de la figure 8.

Sur les figures, les échelles et les proportions ne sont pas strictement respectées et ce, à des fins d'illustration et de clarté.

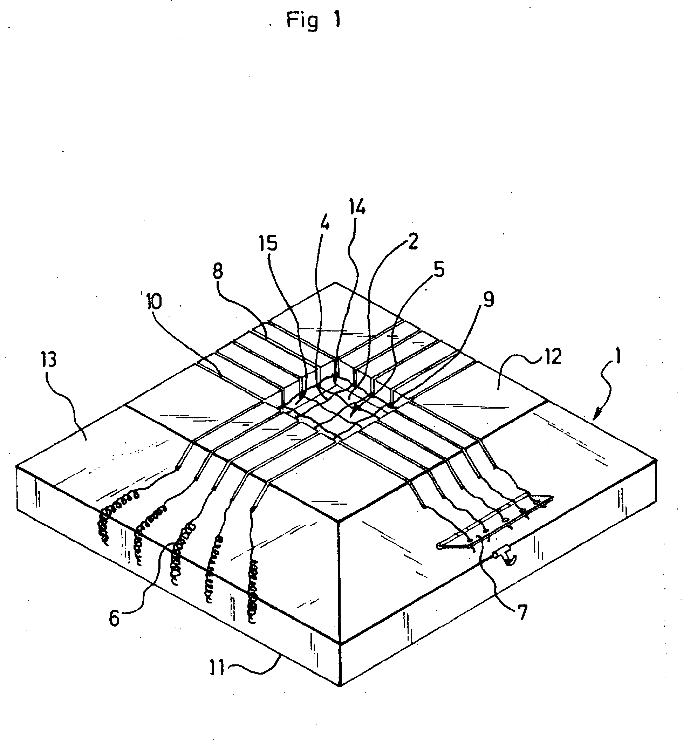

Un dispositif d'alignement de plaquettes 3 d'épaisseur e sur un support 2 plan de réception des plaquettes 3 selon l'invention comprend, tel que représenté sur la figure 1, un corps 1 fixe par rapport au support 2 plan de réception des plaquettes 3.

Selon un mode préférentiel de réalisation de l'invention et tel que représenté sur les figures, le corps 1 et le support 2 plan de réception des plaquettes 3 sont formés d'un seul tenant par une pièce usinée ou issue d'un moulage. Selon ce mode de réalisation, le corps 1 est un bloc d'aluminium présentant une face 11 inférieure de repos du dispositif sur un support quelconque, tel qu'une paillasse de laboratoire, une face 12 supérieure opposée verticalement à la face 11 inférieure et une portion 13 périphérique reliant la face 11 inférieure à la face 12 supérieure.

De préférence, la portion 13 périphérique entoure le support 2 plan de réception des plaquettes 3.

Dans toute la suite, le dispositif selon l'invention est décrit tel que posé horizontalement sur une surface plane horizontale telle qu'une paillasse de laboratoire.

Selon le mode de réalisation des figures; le dispositif comprend un logement 14 de réception ménagé dans le corps 1 et débouchant sur la face 11 supérieure du corps 1. Ce logement 14 de réception présente un fond plan horizontal formant le support 2 plan de réception des plaquettes et des flancs 15 latéraux s'étendant verticalement et délimitant latéralement le support 2 plan de réception des plaquettes 3.

Un dispositif selon l'invention est destiné par exemple à permettre le collage de plaquettes 3 sur un substrat 20. Aussi, selon un mode préférentiel de réalisation d'un dispositif selon l'invention, la distance entre la surface 11 supérieure du corps 1 et le fond du logement de réception formant le support 2 plan de réception des plaquettes 3, c'est-à-dire, la hauteur des flancs 15 latéraux du logement de réception, est au moins égale à la somme de l'épaisseur e des plaquettes 3 et de l'épaisseur *e*' du substrat 20.

Un dispositif selon l'invention comprend en outre des fils 4 de guidage agencés au-dessus du support 2 plan de réception des plaquettes 3 à une distance *d* du support 2 plan inférieure à e et délimitant une pluralité de mailles 5.

Ces fils 4 de guidage peuvent être de tous types. Selon un mode préférentiel de réalisation de l'invention, ces fils 4 de guidage sont des fils en nylon faiblement élastiques.

Un dispositif selon l'invention comprend en outre, tel que représenté sur les figures, des dispositifs 6, 7 de traction des fils 4 de guidage fixés sur le corps 1. De préférence, ces dispositifs 6, 7 de fixation sont fixés sur la portion 13 périphérique du corps 1.

Ces dispositifs 6, 7 de traction sont adaptés pour permettre le déplacement des fils 4 de guidage d'une première position dans laquelle les fils 4 de guidage sont détendus de sorte que les mailles 5 délimitées par ces fils puissent présenter des formes et dimensions radiales supérieures aux dimensions radiales des plaquettes 3 pour que chaque plaquette 3 puisse être logée dans une maille 5, à une deuxième position dans laquelle les fils 4 de guidage sont maintenus en tension parallèlement au support 2 plan de sorte que chaque plaquette 3 logée dans une maille 5 est circonscrite latéralement par les fils 4 de guidage formant cette maille 5.

Cela permet d'assurer un alignement des plaquettes 3 les unes par rapport aux autres le long des fils 4 de guidage, deux plaquettes 3 adjacentes étant espacées l'une de l'autre du diamètre du fil 4 de guidage en traction les séparant.

Ces dispositifs 6, 7 de traction des fils 4 de guidage peuvent être de tous types.

Selon le mode de réalisation des figures, chaque dispositif 6, 7 de traction comprend un ressort 6 présentant une première extrémité 61 fixée au corps 1 du dispositif et une seconde extrémité 62 reliée à une première extrémité d'un fil 4 de guidage, et une poignée 7 de traction agencée à l'opposé du ressort 6 par rapport au support 2 plan et reliée à une deuxième extrémité de ce fil 4 de guidage.

Cette poignée 7 est mobile et est adaptée pour passer d'au moins d'une première position dans laquelle le fil 4 de guidage auquel elle est reliée est détendu à une deuxième position dans laquelle ce fil 4 de guidage est en traction.

Les figures 1, 2a, 2b, 3a, 3b et 7 présentent la poignée 7 mobile dans la position dans laquelle les fils 4 de guidage reliés à cette poignée 7 sont détendus.

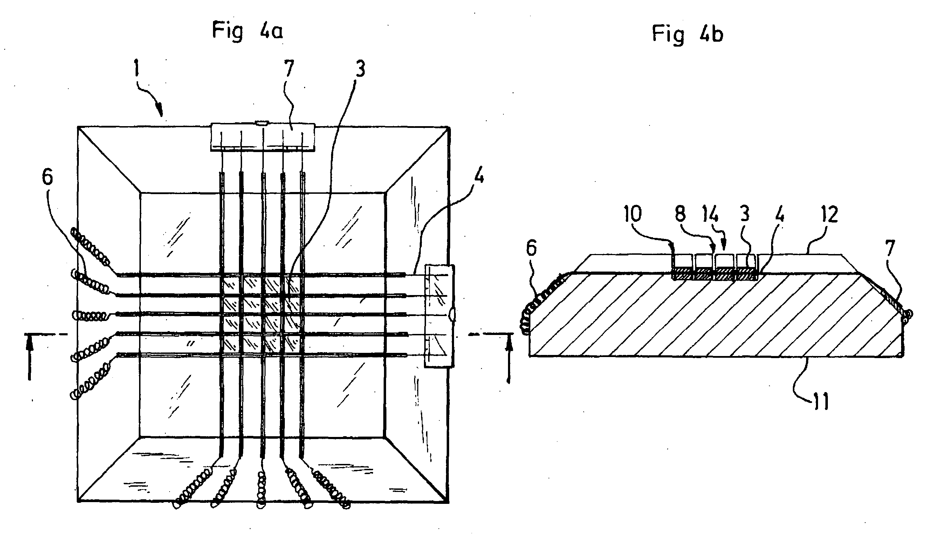

Les figures 4a, 4b, 5, 6a, 6b, 8 et 9a présentent la poignée 7 mobile dans la position dans laquelle les fils 4 de guidage reliés à cette poignée 7 sont tendus.

Selon un mode préférentiel de réalisation et tel que représenté sur les figures, le corps 1 du dispositif comprend une pluralité de fentes 8 adaptées pour former des guides rectilignes de tenue des fils 4 de guidage.

Chaque fente 8 s'étend d'une part radialement entre la portion 13 périphérique du corps 1 et le support 2 plan de réception des plaquettes 3, et d'autre part verticalement entre la face 12 supérieure du corps 1 et un fond 9 de fente parallèle au support 2 plan de réception des plaquettes 3 agencé à une distance *d* au-dessus du support 2 plan de réception des plaquettes 3.

Selon d'autres modes de réalisation, le fond 9 de fente peut être agencé à une distance, du support 2 plan, différente de d. La seule exigence à respecter est que cette distance soit au plus égale à *d* de manière qu'un fil 4 de guidage puisse être maintenu à une distance *d* du support 2 plan de réception des plaquettes 3.

Chaque fente 8 est en outre agencée de sorte qu'elle soit en regard d'une autre fente 8 agencée à l'opposé de cette fente par rapport au support 2 de réception des plaquettes 3 de manière que la paire de fentes ainsi définie forme un guide rectiligne de maintien d'un fil 4 de guidage.

Selon le mode de réalisation des figures, le dispositif comprend en outre des fentes, dites fentes 10 de bordure, ménagées dans le corps 1 du dispositif de sorte que des fils 4 de guidage placés dans ces fentes 10 de bordure s'étendent le long des bords périphériques du support 2 de réception des plaquettes 3.

Ces fentes 10 de bordures permettent l'insertion de fils 4 de guidage le long des bords périphériques du support 2 de réception des plaquettes 3, ce qui permet de ménager un espace entre le bord du support 2 plan et les plaquettes 3.

Selon le mode de réalisation des figures, les fils 4 de guidage logés dans les fentes 10 de bordures présentent un diamètre de 150 µm et les fils 4 de guidage logés dans les fentes 8 présentent un diamètre de 300 µm.

Un dispositif selon le mode de réalisation des figures présente un maillage carré constitué de seize mailles individuelles.

Pour ce faire, le dispositif comprend vingt fentes réparties régulièrement sur le pourtour du corps 1. Les fentes agencées d'un même côté du dispositif sont espacées l'une de l'autre d'une distance égale au côté d'une plaquette 3.

Rien n'empêche de prévoir des dispositifs présentant un plus grand nombre de fentes de manière à pouvoir aligner un plus grand nombre de plaquettes selon un maillage différent.

Selon un mode de réalisation de l'invention, les plaquettes 3 sont des cristaux parallélépipédiques adaptés pour permettre la fabrication de détecteurs X ou gamma. De tels cristaux présentent par exemple une épaisseur de 2 mm et une section droite transversale carrée dont chaque côté mesure 4 mm.

Un dispositif selon l'invention est particulièrement adapté à la mise en oeuvre d'un procédé de collage de plaquettes 3 sur un substrat 20 solide.

Un tel substrat 20 solide est par exemple un substrat plan tel qu'une plaque de céramique.

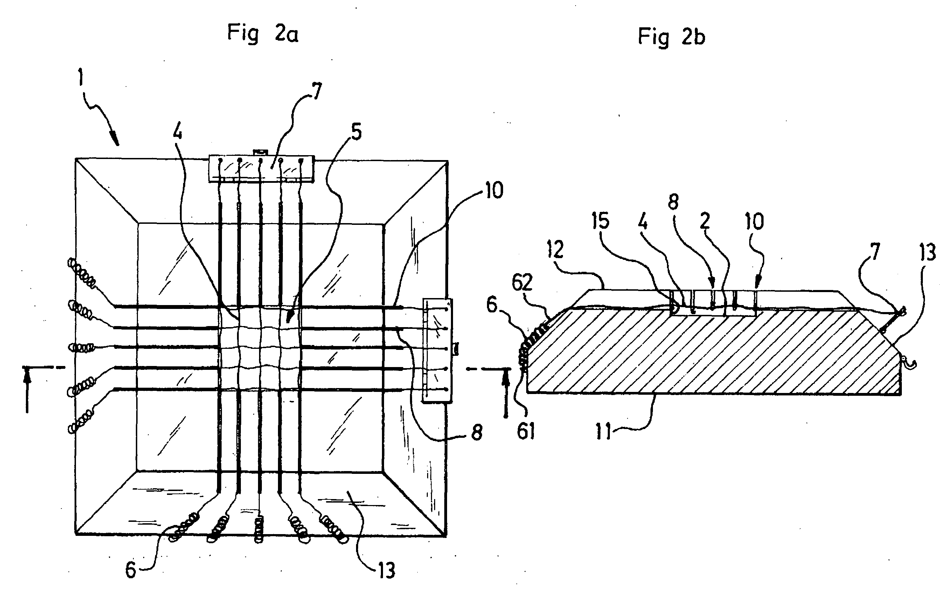

Un procédé d'alignement selon l'invention comprend une première étape, telle que représentée sur les figures 2a et 2b, dans laquelle la pluralité de fils 4 de guidage est disposée parallèlement au-dessus du support 2 plan de réception des plaquettes 3 du dispositif d'alignement selon l'invention à une distance *d* du support 2 plan inférieure à e.

Ainsi, ces fils 4 de guidage définissent un maillage dont chaque maille 5 présente des formes et dimensions adaptées pour recevoir une plaquette 3.

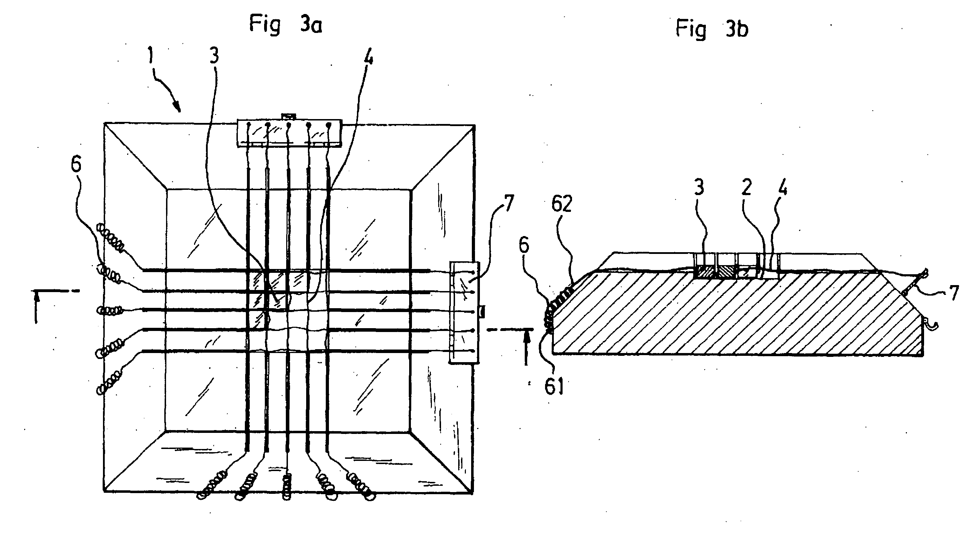

Dans une étape suivante, représentée sur les figures 3a et 3b, chaque plaquette 3 à coller sur le substrat 20 est agencée dans une maille 5 du maillage de sorte qu'une fois positionnée, cette plaquette 3 repose sur le support 2 plan du dispositif d'alignement selon l'invention et est entourée par les fils 4 de guidage définissant la maille 5 dans laquelle la plaquette 3 est agencée.

Dans une étape suivante, telle que représentée sur les figures 4a et 4b, les fils 4 de guidage sont maintenus en traction parallèlement au support 2 plan de sorte que chaque plaquette 3 logée dans une maille 5 est circonscrite par les fils 4 de guidage formant cette maille 5, de manière à assurer un alignement des plaquettes 3 les unes par rapport aux autres le long des fils 4 de guidage.

Ainsi, deux plaquettes 3 adjacentes sont espacées l'une de l'autre du diamètre du fil 4 de guidage en traction les séparant.

Un tel procédé d'alignement permet par exemple de faciliter et d'améliorer le collage de plaquettes sur un substrat solide.

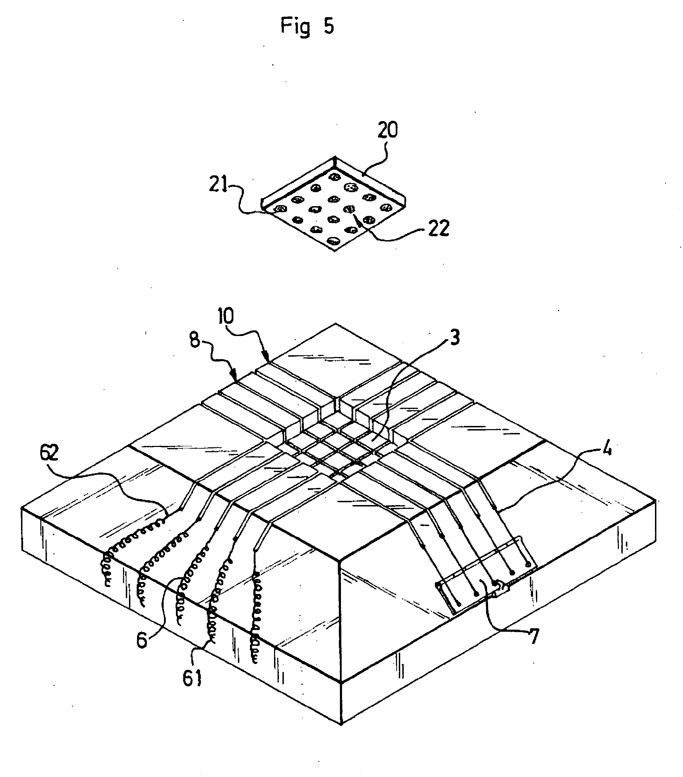

Pour ce faire, dans une étape suivante, telle que représentée sur la figure 5, une pluralité de points 21 de colle est déposée sur une face du substrat 20 solide, dite face 22 collante. La répartition des points 21 de colle sur la face collante du substrat solide est sensiblement identique à la répartition des plaquettes 3 sur le support plan de telle sorte que chaque point 21 de colle permette le collage d'une plaquette 3 sur le substrat 20 solide.

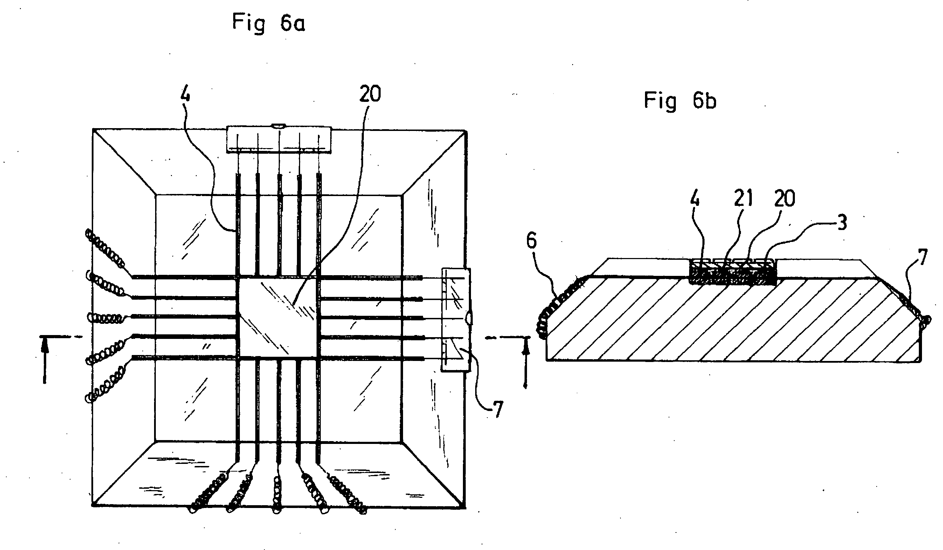

Dans une étape suivante, telle que représentée sur les figures 6a et 6b, le substrat 20 solide est plaqué contre les plaquettes 3, la face 22 collante vers les plaquettes 3.

La colle peut être de tous types connus. De préférence, cette colle est choisie de telle sorte qu'elle soit compatible avec les applications pour lesquelles un tel substrat est fabriqué.

Par exemple, dans le cas de la fabrication d'un détecteur de rayonnements X ou gamma, cette colle est une colle conductrice.

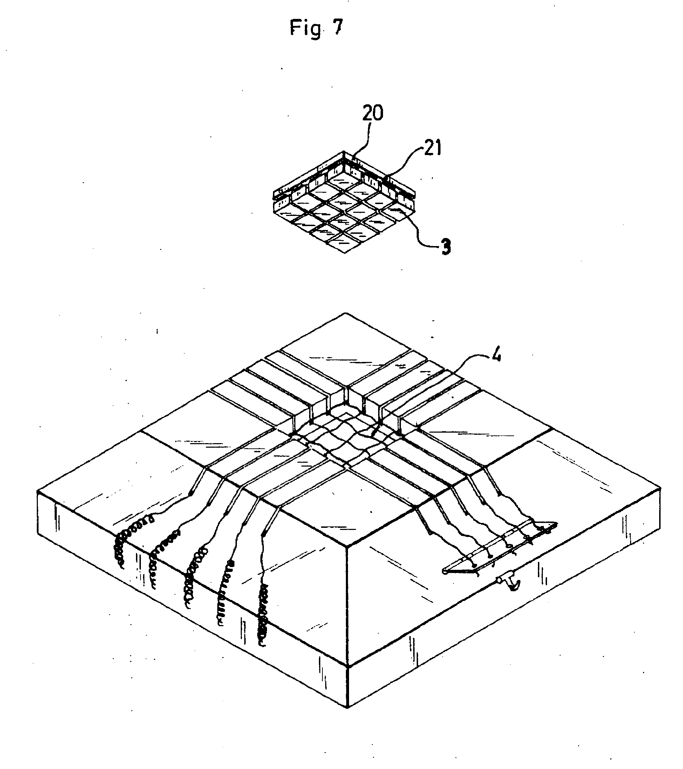

Dans une étape suivante, représentée sur la figure 7, après un laps de temps prédéterminé pendant lequel la colle sèche, les fils 4 de guidage sont détendus et le substrat 20 est éloigné du dispositif d'alignement selon l'invention. Les plaquettes 3 sont collées sur la face 22 collante du substrat 20 suivant le maillage précédemment défini par la pluralité des fils 4 de guidage.

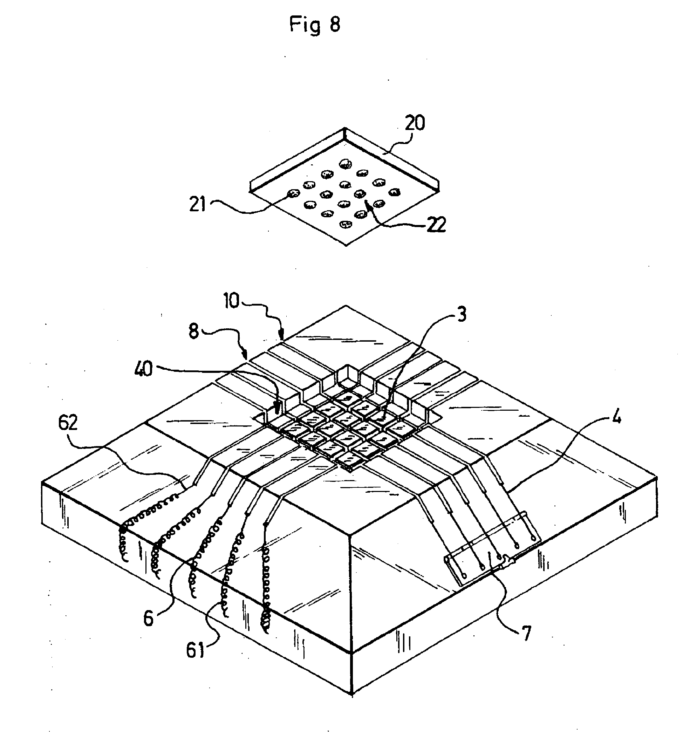

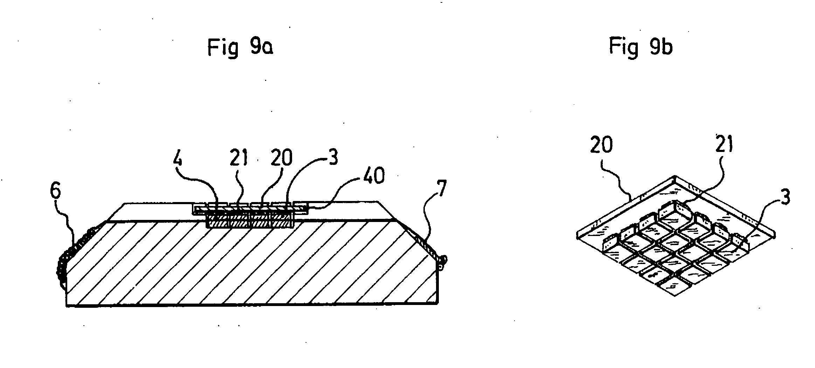

Selon une variante de l'invention telle que représentée sur les figures 8 et 9a, un dispositif d'alignement selon l'invention comprend un épaulement 40 périphérique agencé autour du support plan.

Cet épaulement 40 périphérique est adapté pour retenir le substrat 20 solide de manière qu'il ne vienne pas écraser les points 21 de colle contre les plaquettes 3 lors du plaquage du substrat 20 solide. Cet épaulement 40 périphérique est ménagé sur le pourtour du dispositif d'alignement à une distance choisie de manière que l'écrasement des points 21 de colle soit adapté au collage de chaque plaquette 3 sur le substrat 20 solide. Cette distance dépend notamment du type de colle utilisée et de la quantité de colle déposée sur le substrat 20 solide.

La figure 9a présente le dispositif d'alignement selon ce mode de réalisation dans lequel le substrat 20 solide a été plaqué contre l'épaulement 40 périphérique.

La figure 9b présente le substrat 20 solide extrait du dispositif selon le mode de réalisation des figures 8 et 9a.

Un procédé selon l'invention contribue ainsi par exemple à la réalisation de capteurs de détection de rayonnements X ou gamma par le collage de cristaux semi-conducteurs sur une plaque de céramique.

L'invention ne se limite pas aux seuls modes de réalisation décrits.

En particulier, un dispositif selon l'invention peut présenter plusieurs maillages superposés de manière à permettre l'alignement de plaquettes de toutes épaisseurs. En outre, ces maillages peuvent présenter diverses formes et dimensions.

## Revendications

1. Dispositif d'alignement de plaquettes (3) sur un support (2) plan comprenant :
- un corps (1) fixe par rapport au support (2) plan, **caractérisé en ce qu'**il comprend :
- des fils (4) de guidage agencés au-dessus du support (2) plan et délimitant une pluralité de mailles (5),
- des dispositifs (6, 7) de traction des fils (4) de guidage, ces dispositifs de traction étant fixés sur le corps (1) et adaptés pour permettre le placement des fils (4) de guidage :
. dans au moins une première position, dite position de pose, dans laquelle ils sont détendus de façon à permettre l'insertion de plaquettes (3) dans les mailles (5) délimitées par ces fils (4) de guidage,
dans au moins une deuxième position, dite position d'alignement, dans laquelle les fils (4) de guidage sont tendus et s'étendent au-dessus du support (2) plan de façon à définir des mailles (5) aptes à loger, et à maintenir en place sur le support (2) plan, des plaquettes (3) circonscrites latéralement par les fils (4) de guidage, ces plaquettes (3) étant alignées les unes par rapport aux autres le long des fils (4) de guidage tendus, deux plaquettes (3) logées dans des mailles (5) adjacentes étant espacées l'une de l'autre d'une distance correspondant exactement au diamètre du fil (4) de guidage tendu les séparant.

2. Dispositif selon la revendication 1, adapté pour l'alignement de plaquettes (3) d'épaisseur *e*, **caractérisé en ce que** les dispositifs (6, 7) de traction des fils (4) de guidage sont adaptés pour que, en position d'alignement, chaque fil (4) de guidage s'étende parallèlement au support (2) plan à une distance *d* du support (2) plan inférieure à l'épaisseur *e* des plaquettes (3).

3. Dispositif selon la revendication 2, **caractérisé en ce que** ladite distance *d* est sensiblement égale à *e*/2.

4. Dispositif selon l'une des revendications 1 à 3, **caractérisé en ce que** le corps (1) comprend :
- une portion (13) périphérique entourant au moins partiellement le support (2) plan de réception des plaquettes (3) et sur laquelle sont fixés les dispositifs (6, 7) de traction des fils (4) de guidage,
- une pluralité de fentes (8, 10), chaque fente (8, 10) :
. s'étendant radialement entre la portion (13) périphérique du corps (1) et le support (2) plan de réception des plaquettes (3),
. s'étendant entre une face (12) supérieure du corps (1) et un fond (9) de fente parallèle au support (2) plan de réception des plaquettes (3) agencé à une distance *d* au-dessus du support (2) plan de réception des plaquettes (3),
. étant axialement en regard d'une autre fente (8, 10) agencée dans le corps (1) à l'opposé de cette fente (8, 10) par rapport au support (2) plan de manière que ces fentes (8, 10), axialement en regard l'une de l'autre, d'un côté et de l'autre du support (2) plan, forment une paire de fentes de guidage rectiligne d'un fil (4) de guidage.

5. Dispositif selon la revendication 4, **caractérisé en ce qu'**il comprend des fentes, dites fentes (10) de bordure, ménagées dans le corps (1) du dispositif de sorte que des fils (4) de guidage placés dans ces fentes (10) de bordure s'étendent le long de bords périphériques du support (2) plan.

6. Dispositif selon la revendication 5, **caractérisé en ce que** lesdites fentes (8, 10) sont ménagées dans le corps (1) du dispositif de sorte que le maillage constitué par les fils (4) de guidage placés dans les fentes (8, 10) est un maillage carré.

7. Dispositif selon l'une des revendications 1 à 6, **caractérisé en ce que** chaque dispositif (6, 7) de traction comprend :
- au moins un ressort (6) présentant une première extrémité (61) fixée au corps (1) du dispositif et une seconde extrémité (62) reliée à une première extrémité d'un fil (4) de guidage,
- au moins une poignée (7) mobile de traction agencée à l'opposé du ressort (6) par rapport au support (2) plan et reliée à une deuxième extrémité de ce fil (4) de guidage et adaptée pour passer d'au moins d'une première position dans laquelle ce fil (4) de guidage et ce ressort (6) sont détendus à au moins une deuxième position dans laquelle ce fil (4) de guidage et ce ressort (6) sont en traction.

8. Dispositif selon l'une des revendications 1 à 7, **caractérisé en ce qu'**au moins un fil (4) de guidage est un fil en nylon.

9. Dispositif selon l'une des revendications 1 à 8, **caractérisé en ce qu'**au moins un fil (4) de guidage est un fil dont le diamètre en traction est de 300 µm de telle sorte que deux plaquettes (3) adjacentes séparées par ce fil (4) de guidage soit espacée l'une de l'autre de 300 µm.

10. Dispositif selon l'une des revendications 1 à 9, **caractérisé en ce que** le corps (1) comprend un logement (14) de réception des plaquettes (3) formé du support (2) plan et de flancs (15) latéraux s'étendant perpendiculairement au support (2) plan de manière à délimiter latéralement le support (2) plan.

11. Dispositif selon la revendication 10, **caractérisé en ce que** le logement (14) de réception présente une forme et des dimensions adaptées pour permettre la réception sur les plaquettes (3) d'un substrat (20) solide adapté pour être plaqué contre les plaquettes (3) parallèlement au support plan (2), les plaquettes (3) étant ainsi prises en sandwich entre le support (2) plan et ce substrat (20) solide.

12. Dispositif selon la revendication 11, **caractérisé en ce que** le logement (14) de réception comporte un épaulement (40) périphérique adapté pour recevoir une portion périphérique du substrat (20) solide de manière à délimiter, une fois le substrat (20) solide plaqué contre l'épaulement (40) périphérique, un espace entre la surface supérieure des plaquettes (3) et la surface inférieure du substrat (20) solide logé dans ce logement de réception.

13. Dispositif selon les revendications 4 et 11 prises ensemble, **caractérisé en ce que** les fentes (10) de bordure sont adaptées pour recevoir un fil (4) de guidage présentant un diamètre en traction de 150 µm de telle sorte que les plaquettes (3) agencées aux bords du support (2) plan de réception des plaquettes (3) puissent être espacées du bord d'un substrat (20) solide logé dans le logement (14) de réception d'une distance égale à 150 µm.

14. Dispositif selon l'une des revendications 1 à 13, **caractérisé en ce que** les plaquettes (3) sont des cristaux parallélépipédiques adaptés pour permettre la détection de rayonnements X ou y, chaque cristal présentant une épaisseur de l'ordre de 2 mm.

15. Procédé d'alignement de plaquettes (3) sur un support (2) plan **caractérisé en ce qu'**il comprend les étapes suivantes :
- une pluralité de fils (4) de guidage est disposée au-dessus du support (2) plan de manière à délimiter une pluralité de mailles (5),
- les fils (4) de guidage sont placés dans une première position, dite position de pose, dans laquelle ils sont détendus de façon à permettre l'insertion desdites plaquettes (3) dans les mailles (5) délimitées par ces fils (4) de guidage,
- chaque plaquette (3) à aligner sur le support (2) plan est agencée dans une maille (5) de sorte qu'une fois positionnée, elle repose sur le support (2) plan et est entourée par les fils (4) de guidage définissant la maille (5) dans laquelle cette plaquette (3) est agencée,
- les fils (4) de guidage sont placés dans une deuxième position, dite position d'alignement, dans laquelle les fils (4) de guidage sont tendus et s'étendent au-dessus du support (2) plan de façon à définir des mailles (5) aptes à loger, et à maintenir en place sur le support (2) plan, lesdites plaquettes (3) circonscrites latéralement par les fils (4) de guidage, ces plaquettes (3) étant alignées les unes par rapport aux autres le long des fils (4) de guidage tendus, deux plaquettes (3) logées dans des mailles (5) adjacentes étant espacées l'une de l'autre d'une distance correspondant exactement au diamètre du fil (4) de guidage tendu les séparant.

## Claims

1. Device for aligning wafers (3) on a plane base (2), comprising:
- a body (1) which is fixed relative to the plane base (2), **characterized in that** it comprises:
- guiding wires (4), which are arranged above the plane base (2) and delimit multiple meshes (5),
- devices (6, 7) for pulling the guiding wires (4), these pulling devices being fixed on the body (1) and suitable for making it possible to position the guiding wires (4):
• in at least one first position, called the fitting position, in which they are slackened so as to permit the insertion of wafers (3) into the meshes (5) delimited by these guiding wires (4),
• in at least one second position, called the alignment position, in which the guiding wires (4) are stretched and extend above the plane base (2) so as to define meshes (5) which are suitable for housing, and maintaining in place on the plane base (2), wafers (3) which are circumscribed laterally by the guiding wires (4), these wafers (3) being aligned relative to each other along the stretched guiding wires (4), two wafers (3) housed in adjacent meshes (5) being at a distance from each other corresponding exactly to the diameter of the stretched guiding wire (4) which separates them.

2. Device according to Claim 1, suitable for aligning wafers (3) of thickness e, **characterized in that** the devices (6, 7) for pulling the guiding wires (4) are suitable so that, in the alignment position, each guiding wire (4) extends parallel to the plane base (2) at a distance d from the plane base (2) less than the thickness e of the wafers (3).

3. Device according to Claim 2, **characterized in that** said distance d approximately equals e/2.

4. Device according to any one of Claims 1 to 3, **characterized in that** the body (1) comprises:
- a peripheral portion (13) which at least partially surrounds the plane base (2) for receiving the wafers (3), and on which the devices (6, 7) for pulling the guiding wires (4) are fixed,
- multiple slits (8, 10), each slit (8, 10):
• extending radially between the peripheral portion (13) of the body (1) and the plane base (2) for receiving the wafers (3),
• extending between an upper face (12) of the body (1) and a bottom (9) of a parallel slit to the plane base (2) for receiving the wafers (3), said bottom being arranged at a distance d above the plane base (2) for receiving the wafers (3),
• axially facing another slit (8, 10) which is arranged in the body (1) opposite this slit (8, 10) relative to the plane base (2), in such a way that these slits (8,10), facing each other axially, on one side and the other of the plane base (2), form a pair of slits for rectilinear guidance of a guiding wire (4).

5. Device according to Claim 4, **characterized in that** it includes slits, called edging slits (10), which are made in the body (1) of the device so that the guiding wires (4) which are placed in these edging slits (10) extend along the peripheral edges of the plane base (2).

6. Device according to Claim 5, **characterized in that** said slits (8, 10) are made in the body (1) of the device so that the grid formed by the guiding wires (4) placed in the slits (8, 10) is a square grid.

7. Device according to any one of Claims 1 to 6, **characterized in that** each pulling device (6, 7) comprises:
- at least one spring (6) having a first fixed extremity (61) which is fixed to the body (1) of the device, and a second extremity (62) which is connected to a first extremity of a guiding wire (4),
- at least one movable pulling handle (7), which is arranged opposite the spring (6) relative to the plane base (2), and connected to a second extremity of this guiding wire (4), and suitable for passing from at least one first position, in which this guiding wire (4) and this spring (6) are slackened, to at least one second position in which this guiding wire (4) and this spring (6) are in traction.

8. Device according to any one of Claims 1 to 7, **characterized in that** at least one guiding wire (4) is a nylon wire.

9. Device according to any one of Claims 1 to 8, **characterized in that** at least one guiding wire (4) is a wire of which the diameter in traction is 300 µm, so that two adjacent wafers (3) separated by this guiding wire (4) are at a distance of 300 µm from each other.

10. Device according to any one of Claims 1 to 9, **characterized in that** the body (1) includes a housing (14) for receiving the wafers (3), this housing being formed of the plane base (2) and lateral flanks (15) which extend perpendicularly to the plane base (2) so as to delimit the plane base (2) laterally.

11. Device according to Claim 10, **characterized in that** the receiving housing (14) has a shape and dimensions which are suitable for allowing reception on the wafers (3) of a solid substrate (20) which is suitable for being pressed against the wafers (3) parallel to the plane base (2), these wafers (3) thus being taken into a sandwich between the plane base (2) and this solid substrate (20).

12. Device according to Claim 11, **characterized in that** the receiving housing (14) includes a peripheral shoulder (40) which is suitable for receiving a peripheral portion of the solid substrate (20) so as to delimit, once the solid substrate (20) is pressed against the peripheral shoulder (40), a space between the upper surface of the wafers (3) and the lower surface of the solid substrate (20) which is housed in this receiving housing.

13. Device according to Claims 4 and 11 taken together, **characterized in that** the edging slits (10) are suitable for receiving a guiding wire (4) having a diameter in traction of 150 µm, so that the wafers (3) arranged on the edges of the plane base (2) for receiving the wafers (3) can be at a distance equal to 150 µm from the edge of a solid substrate (20) housed in the receiving housing (14).

14. Device according to any one of Claims 1 to 13, **characterized in that** the wafers (3) are parallelepipedic crystals which are suitable for making it possible to detect X-rays or γ rays, each crystal having a thickness of the order of 2 mm.

15. Method of aligning wafers (3) on a plane base (2), **characterized in that** it includes the following steps:
- multiple guiding wires (4) are arranged above the plane base (2) so as to delimit multiple meshes (5),
- the guiding wires (4) are placed in at least one first position, called the fitting position, in which they are slackened so as to permit the insertion of said wafers (3) into the meshes (5) delimited by these guiding wires (4),
- each wafer (3) to be aligned on the plane base (2) is arranged in a mesh (5) so that once it is positioned, it rests on the plane base (2) and is surrounded by the guiding wires (4) which define the mesh (5) in which this wafer (3) is arranged,
- the guiding wires (4) are placed in a second position, called the alignment position, in which the guiding wires (4) are stretched and extend above the plane base (2) so as to define meshes (5) which are suitable for housing, and maintaining in place on the plane base (2), said wafers (3) which are circumscribed laterally by the guiding wires (4), these wafers (3) being aligned relative to each other along the stretched guiding wires (4), two wafers (3) housed in adjacent meshes (5) being at a distance from each other corresponding exactly to the diameter of the stretched guiding wire (4) which separates them.

## Patentansprüche

1. Vorrichtung für das Ausrichten von Plättchen (3) auf einem ebenen Träger (2) mit folgenden Teilen:
- ein gegenüber dem ebenen Träger (2) fixer Körper (1), **dadurch gekennzeichnet, dass** er folgende Teile umfasst:
- Führungsfäden (4), die über dem ebenen Träger (2) gestaltet sind und eine Mehrzahl von Maschen (5) abgrenzen,
- Zugvorrichtungen (6, 7) für die Führungsfäden (4), wobei diese Zugvorrichtungen auf dem Körper (1) befestigt und geeignet sind, das Anordnen der Führungsfäden (4) zu ermöglichen:
. in mindestens einer ersten Position, der sogenannten Verlegeposition, in der sie so entspannt werden, dass Plättchen (3) in die durch diese Führungsfäden (4) abgegrenzten Maschen (5) eingesetzt werden können,
• in mindestens einer zweiten Position, der sogenannten Ausrichtungsposition, in der die Führungsfäden (4) gespannt werden und sich über dem ebenen Träger (2) erstrecken, sodass Maschen (5) definiert werden, die geeignet sind, Plättchen (3) aufzunehmen und auf dem ebenen Träger (2) an Ort und Stelle zu halten, die seitlich von den Führungsfäden (4) umgrenzt werden, wobei diese Plättchen (3) an den gespannten Führungsfäden (4) entlang zueinander ausgerichtet werden, wobei zwei Plättchen (3), die in angrenzenden Maschen (5) aufgenommen werden, voneinander um einen Abstand getrennt sind, der genau dem Durchmesser des gespannten Führungsfadens (4) entspricht, der sie trennt.

2. Vorrichtung nach Anspruch 1, die für die Ausrichtung von Plättchen (3) der Dicke e geeignet ist, **dadurch gekennzeichnet, dass** die Zugvorrichtungen (6, 7) der Führungsfäden (4) geeignet sind, damit sich jeder Führungsfaden (4) in Ausrichtungsposition parallel zum ebenen Träger (2) in einem Abstand *d* vom ebenen Träger (2) erstreckt, der geringer als die Dicke e der Plättchen (3) ist.

3. Vorrichtung nach Anspruch 2, **dadurch gekennzeichnet, dass** der besagte Abstand d deutlich gleich *e*/2 ist.

4. Vorrichtung nach einem beliebigen der vorstehenden Ansprüche 1 bis 3, **dadurch gekennzeichnet, dass** der Körper folgende Elemente umfasst:
- einen peripheren Abschnitt (13), der den ebenen Träger (2) für die Aufnahme der Plättchen (3) zumindest teilweise umgibt, und auf dem die Zugvorrichtungen (6, 7) für die Führungsfäden (4) befestigt sind,
- eine Mehrzahl von Schlitzen (8, 10), wobei jeder Schlitz (8, 10):
• sich radial zwischen dem peripheren Abschnitt (13) des Körpers (1) und dem ebenen Träger (2) für die Aufnahme der Plättchen (3) erstreckt,
• sich zwischen einer oberen Fläche (12) des Körpers (1) und einem Schlitzboden (9) parallel zum ebenen Träger (2) für die Aufnahme der Plättchen (3) erstreckt, der in einem Abstand *d* über dem ebenen Träger (2) für die Aufnahme der Plättchen (3) gestaltet ist,
• axial gegenüber einem anderen Schlitz (8, 10) ist, der im Körper (1) entgegengesetzt zu diesem Schlitz (8, 10) gegenüber dem ebenen Träger (2) gestaltet ist, sodass diese Schlitze (8, 10), die axial zueinander auf der einen und der anderen Seite des ebenen Trägers (2) verlaufen, ein Paar Schlitze für die geradlinige Führung eines Führungsfadens (4) bilden.

5. Vorrichtung nach Anspruch 4, **dadurch gekennzeichnet, dass** sie Schlitze, sogenannte Randschlitze (10) umfasst, die so im Körper (1) der Vorrichtung gestaltet sind, dass sich die in diesen Randschlitzen (10) platzierten Führungsfäden (4) entlang von peripheren Kanten des ebenen Trägers (2) erstrecken.

6. Vorrichtung nach Anspruch 5, **dadurch gekennzeichnet, dass** die besagten Schlitze (8, 10) so im Körper (1) der Vorrichtung gestaltet sind, dass das durch die in den Schlitzen (8, 10) platzierten Führungsfäden (4) gebildete Netzwerk ein quadratisches Netzwerk ist.

7. Vorrichtung nach einem beliebigen der vorstehenden Ansprüche 1 bis 6, **dadurch gekennzeichnet, dass** jede Zugvorrichtung (6, 7) folgende Elemente umfasst:
- zumindest eine Feder (6), die ein erstes Ende (61) aufweist, das am Körper (1) der Vorrichtung befestigt ist, und ein zweites Ende (62), das mit einem ersten Ende eines Führungsfadens (4) verbunden ist,
- zumindest einen mobilen Ziehgriff (7), der entgegengesetzt zur Feder (6) im Verhältnis zum ebenen Träger (2) gestaltet und mit einem zweiten Ende dieses Führungsfadens (4) verbunden und geeignet ist, von zumindest einer ersten Position, in der dieser Führungsfaden (4) und diese Feder (6) entspannt sind, zu mindestens einer zweiten Position überzugehen, in der dieser Führungsfaden (4) und diese Feder (6) gezogen werden.

8. Vorrichtung nach einem beliebigen der vorstehenden Ansprüche 1 bis 7, **dadurch gekennzeichnet, dass** zumindest ein Führungsfaden (4) ein Nylonfaden ist.

9. Vorrichtung nach einem beliebigen der vorstehenden Ansprüche 1 bis 8, **dadurch gekennzeichnet, dass** zumindest ein Führungsfaden (4) ein Faden ist, dessen Durchmesser bei Zug 300 µm beträgt, so dass zwei durch diesen Führungsfaden (4) getrennte angrenzende Plättchen (3) um 300 µm voneinander getrennt sind.

10. Vorrichtung nach einem beliebigen der vorstehenden Ansprüche 1 bis 9, **dadurch gekennzeichnet, dass** der Körper (1) einen Sitz (14) für die Aufnahme der Plättchen (3) umfasst, der aus dem ebenen Träger (2) und seitlichen Flanken (15) gebildet wird, die sich senkrecht zum ebenen Träger (2) erstrecken, so dass sie den ebenen Träger (2) seitlich abgrenzen.

11. Vorrichtung nach Anspruch 10, **dadurch gekennzeichnet, dass** der Aufnahmesitz (14) eine Form und Abmessungen aufweist, die dazu geeignet sind, die Aufnahme eines festen Substrats (20) auf den Plättchen (3) zuzulassen, das geeignet ist, an die Plättchen (3) parallel zum ebenen Träger (2) angedrückt zu werden, wobei die Plättchen (3) somit wie ein Sandwich zwischen dem ebenen Träger (2) und diesem festen Substrat (20) gefasst werden.

12. Vorrichtung nach Anspruch 11, **dadurch gekennzeichnet, dass** der Aufnahmesitz (14) eine periphere Schulter (40) umfasst, die geeignet ist, einen peripheren Abschnitt des festen Substrats (20) aufzunehmen, so dass, wenn das feste Substrat (20) an die periphere Schulter (40) angedrückt ist, ein Raum zwischen der oberen Fläche der Plättchen (3) und der unteren Fläche des festen Substrats (20) abgegrenzt wird, das in diesem Aufnahmesitz aufgenommen wird.

13. Vorrichtung nach den Ansprüchen 4 und 11, die gemeinsam genommen werden, **dadurch gekennzeichnet, dass** die Randschlitze (10) dazu geeignet sind, einen Führungsfaden (4) aufzunehmen, der einen Zugdurchmesser von 150 µm aufweist, sodass die an den Rändern des ebenen Trägers (2) für die Aufnahme der Plättchen (3) gestalteten Plättchen (3) von der Kante eines im Aufnahmesitz (14) untergebrachten festen Substrats (20) um einen Abstand von gleich 150 µm getrennt werden können.

14. Vorrichtung nach einem beliebigen der vorstehenden Ansprüche 1 bis 13, **dadurch gekennzeichnet, dass** die Plättchen (3) quaderförmige Kristalle und geeignet sind, das Entdecken von X oder Y Strahlen zu erlauben, wobei jedes Kristall eine Stärke von circa 2 mm aufweist.

15. Verfahren für das Ausrichten von Plättchen (3) auf einem ebenen Träger (2), **dadurch gekennzeichnet, dass** es die folgenden Schritte umfasst:
- eine Mehrzahl von Führungsfäden (4) sind über dem ebenen Träger (2) angeordnet, sodass eine Mehrzahl von Maschen (5) abgegrenzt wird,
- die Führungsfäden (4) sind in einer ersten Position, der sogenannten Verlegeposition, platziert, in der sie entspannt sind, sodass sie das Einsetzen der besagten Plättchen (3) in die Maschen (5) zulassen, die von diesen Führungsfäden (4) abgegrenzt werden,
- jedes auf dem ebenen Träger (2) auszurichtende Plättchen (3) ist in einer Masche (5) gestaltet, sodass es nach dem Positionieren auf dem ebenen Träger (2) ruht und von den Führungsfäden (4) umgeben wird, die die Masche (5) definieren, in der dieses Plättchen (3) gestaltet ist,
- die Führungsfäden (4) werden in einer zweiten Position, der sogenannte Ausrichtungsposition, platziert, in der die Führungsfäden (4) gespannt werden und sich so über dem ebenen Träger (2) erstrecken, dass Maschen (5) definiert werden, die geeignet sind, die besagten Plättchen (3) aufzunehmen und auf dem ebenen Träger (2) an Ort und Stelle zu halten, wobei die besagten Plättchen (3) seitlich von den Führungsfäden (4) umgrenzt werden, wobei diese Plättchen (3) an den gespannten Führungsfäden (4) entlang zueinander ausgerichtet werden, wobei zwei Plättchen (3), die in angrenzenden Maschen (5) aufgenommen werden, voneinander um einen Abstand getrennt sind, der genau dem Durchmesser des gespannten Führungsfadens (4) entspricht, der sie trennt.
